Europäisches Patentamt

European Patent Office

Office européen des brevets

(11) Veröffentlichungsnummer: **0 570 608 A1**

## EUROPÄISCHE PATENTANMELDUNG

(21) Anmeldenummer: **92108448.9**

(22) Anmeldetag: **19.05.92**

(51) Int. Cl.5: **G01R 23/10**, G06F 7/62

(43) Veröffentlichungstag der Anmeldung:
**24.11.93 Patentblatt 93/47**

(84) Benannte Vertragsstaaten:
**AT DE FR GB IT SE**

(71) Anmelder: **SIEMENS AKTIENGESELLSCHAFT**
**Wittelsbacherplatz 2**
**D-80333 München(DE)**

(72) Erfinder: **Brune, Richard, Dipl.-Ing.**
**Sonneberger Strasse 38**
**W-8510 Fürth(DE)**
Erfinder: **Hartwig, Hagen, Dipl.-Ing.**
**Paul-Gossen-Strasse 34**
**W-8520 Erlangen(DE)**

(54) **Verfahren und Einrichtung zur Zählung digitaler Impulse.**

(57) Bei der Zählung digitaler Impulse wird auch die Information, die in der Impulslänge steckt ausgewertet. Dies geschieht dadurch, daß bei Beginn einer Periode des digitalen Signals (S) ein gegenüber dem digitalen Signal (S) höherfrequentes Systemtaktsignal (C) mitgezählt wird. Der gebrochen rationale Anteil ergibt sich dann aus der Anzahl der Systemtaktsignale (C) beim Auftreten des Meßtaktsignals (T) dividiert durch die Anzahl der Systemtaktsignale (C) der Periode in der das Meßtaktsignal auftritt.

FIG 1

EP 0 570 608 A1

Die Erfindung betrifft ein Verfahren und eine Einrichtung zur Zählung digitaler Impulse von digitalen Signalen. Die Zählung von Impulsen eines digitalen Signals ist ein häufiger Anwendungsfall der Digitaltechnik. Wenn beispielsweise die Anzahl der Impulse eines digitalen Signals proportional zur Frequenz eines Analogsignals ist, dann ist eine frequenzproportionale Auswertung des digitalen Signals umso genauer, je genauer die Zählung der Impulse gelingt.

In der europäischen Patentanmeldung 04 54 882 wird eine Zählschaltung zur Auswertung eines digitalen Signals mit einem digitalen Zähler vorgeschlagen, bei der eine Verdopplung des Zählerausgangssignals und damit der Impulszählung dadurch erreicht wird, daß das digitale Signal zusätzlich zu den Ausgangssignalen des Zählers verwendet wird.

Durch die Verwendung eines digitalen Zählers können jedoch nur ganze Impulse gezählt werden. Die Information, die in der Impulslänge enthalten ist, kann damit nicht erfaßt werden.

Aufgabe der Erfindung ist es, die Zählung der Impulse von digitalen Signalen zu optimieren.

Diese Aufgabe wird durch ein Verfahren zur Zählung digitaler Impulse gelöst wobei ein digitales Signal mit einem Systemtakt synchronisiert wird, dessen Frequenz größer ist als die doppelte Maximalfrequenz des digitalen Signals wobei zwischen jeweils zwei periodischen Meßtaktsignalen die ganzzahlige Anzahl der Impulse des digitalen Signals gezählt wird, wobei jeweils bei Beginn einer Periode des digitalen Signals eine Zählung des Systemtakts gestartet und die Summe der Systemtakte bis zum Auftreten des Meßtaktsignals als Periodenteilsumme und die Summe der Systemtakte zwischen zwei Meßtaktsignalen als Periodensumme gezählt werden und wobei die Anzahl der digitalen Impulse zwischen zwei Meßtaktsignalen durch die ganzzahlige Anzahl der Impulse und den Quotienten aus der Periodenteilsumme und Periodensumme bestimmt wird.

Durch die Auszählung der einzelnen Impulse mit dem höherfrequenten, dem Abtasttheorem bezüglich des digitalen Signals genügenden Systemtakt, läßt sich auch die Information, die in der Teillänge des zum Meßzeitpunkt detektierten Impulses steckt, noch als nicht ganzzahliger Anteil auswerten.

Nach einer vorteilhaften Ausbildung des Verfahrens kann die Genauigkeit dieser Zählung dadurch erhöht werden, daß das Systemtaktsignal invertiert wird und die Auswertung des digitalen Signals sowohl mit dem "normalen" Systemtaktsignal, als auch mit dem invertierten Systemtaktsignal erfolgt.

In den weiteren Ansprüchen ist eine vorteilhafte Schaltungsanordnung zur Durchführung des Verfahrens beschrieben.

Ein Ausführungsbeispiel der Erfindung wird im folgenden anhand einer Zeichnung näher erläutert. Dabei zeigen:

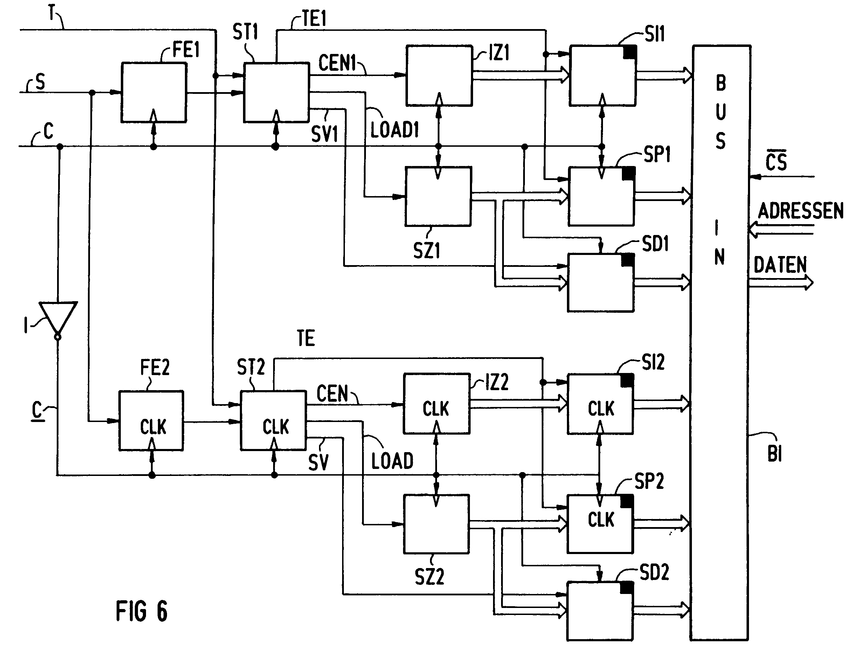

FIG 1
ein Blockschaltbild einer Zählschaltung für ein digitales Signal,
FIG 2 bis FIG 5
Zeitdiagramme von digitalen Signalen,
FIG 6
ein Blockschaltbild einer Zählschaltung mit doppelter Impulsauflösung,
FIG 7 bis FIG 13
die zu FIG 6 gehörenden Impulsdiagramme.

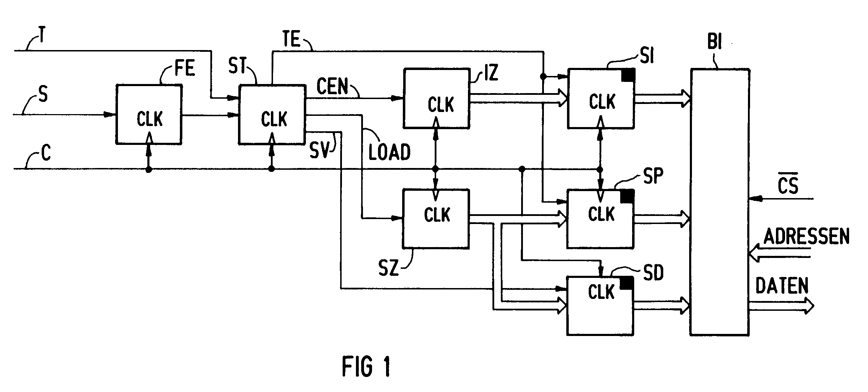

FIG 1 zeigt ein Blockschaltbild zur Zählung der Impulse eines digitalen Signals S, das auf den Eingang einer Flankenerkennung FE geführt ist. Der Ausgang der Flankenerkennung FE ist auf den Eingang einer Steuereinheit ST geführt, die über ihren Ausgang CEN mit einem Impulszähler IZ, über den Ausgang LOAD mit einem Systemtaktzähler SZ und über den Ausgang SV mit einem Speicher SD für die Periodendauer einer jeweiligen Periode des digitalen Signals verbunden ist. Dem Impulszähler IZ ist ein Speicher SI für die ganzzahligen Impulse des digitalen Signals nachgeschaltet; dem Systemtaktzähler SZ ist ein Speicher SP für die Phasenlage sowie ein Speicher SD für die Periodendauer eines Systemtaktsignals C nachgeschaltet. Die Clock-Eingänge CLK der verwendeten Bausteine sind mit einem Systemtaktsignal C beaufschlagt, das gegenüber der Maximalfrequenz des digitalen Signals S das Abtasttheorem erfüllt, d.h. daß das Systemtaktsignal C größer ist als die doppelte Maximalfrequenz des digitalen Signals S (das Abtasttheorem ist auch unter der Bezeichnung Shannon-Theorem bekannt).

Die Steuereinheit ST wird noch mit dem Meßtaktsignal T beaufschlagt, das die Zeitpunkte zu denen die Zählung des digitalen Signals S beginnt bzw. endet, angibt und deshalb niederfrequenter als das digitale Signal S ist. Gängige Frequenzen mit denen die Schaltung betrieben werden kann, sind beispielsweise 1 bis 15 MHz für das digitale Signal, 32 MHz für das Systemtaktsignal C und 16 kHz für das Meßtaktsignal T. Das Steuerwerk ST ist über eine Taktereignisleitung TE mit dem Speicher SI für die Impulse und dem Speicher SP für die Periodendauer verbunden.

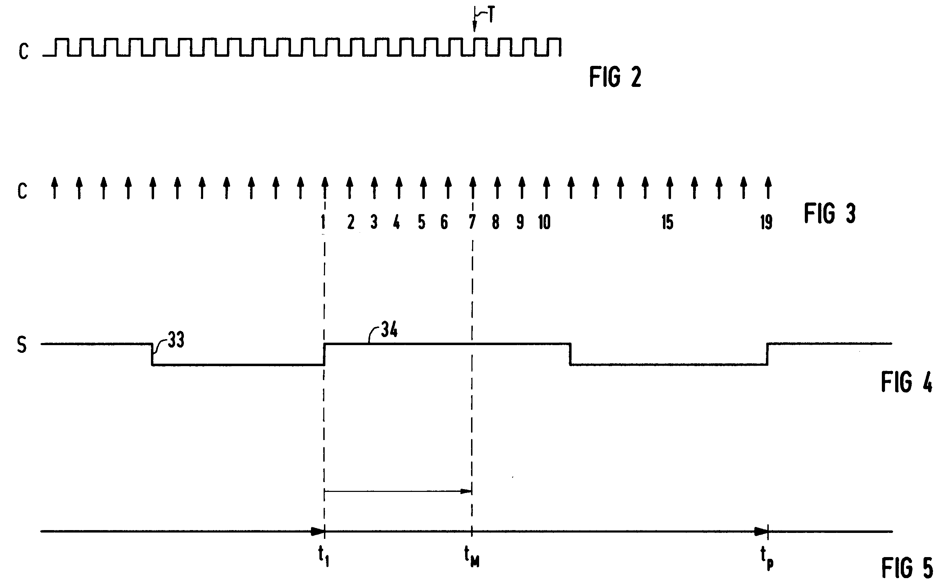

Die Anordnung arbeitet auf folgende Weise. Die Flankenerkennungseinheit FE erkennt die positive Flanke eines Impulses des digitalen Signals S. Über den Eingang CLK der Flankenerkennungseinheit FE wird das digitale Signal S mit dem Systemtaktsignal C synchronisiert, so daß eine positive Flanke des Systemtaktsignals C mit einer positiven Flanke eines Impulses des digitalen Signals S zusammenfällt. Jede positive Flanke eines Impulses des digitalen Signals S wird dem Steuerwerk ST zugeführt, das ein Zählsignal CEN an den Impulszähler IZ abgibt, so daß dieser mit jedem Impuls um den Wert 1 inkrementiert wird. Gleichzeitig wird bei jedem Impuls (Beginn einer Periode) durch das Steuerwerk ST ein LOAD-Signal an den Systemtaktzähler SZ gegeben, so daß dieser rückgesetzt wird und mit der Zählung des Systemtaktes C beginnt. Da der Systemtaktzähler SZ bei jeder positiven Flanke eines Impulses rückgesetzt wird und daraufhin neu mit der Zählung beginnt, wird durch ihn genau eine Periode des digitalen Signals oder, mit anderen Worten, die Länge eines digitalen Impulses und die Länge der darauffolgenden Impulspause in Vielfachen des Systemtakts C gezählt. Beim Auftreten eines Taktsignales T wird vom Steuerwerk ST ein Taktereignissignal TE an den Impulsspeicher SI und den Speicher SP für die Periodendauer gegeben, worauf der Speicher SI die Anzahl der Impulse vom Impulszähler IZ und der Speicher SP die Anzahl der Systemtakte aus dem Systemtaktzähler SZ übernimmt. Der Systemtaktzähler SZ zählt jedoch die Systemtakte C noch bis zum Ende der momentane Perioden des digitalen Signales S weiter. Erst am Ende der Periode wird durch das vom Steuerwerk ST ausgelöste Signal SV der Speicher SD für die Periodendauer aktiviert, worauf dieser die Systemtakte aus dem Systemtaktzähler SZ übernimmt. Beim Auftreten eines Taktsignals T werden also im Speicher SI die ganzzahlige Anzahl der Impulse des digitalen Signals S, im Speicher SP die Anzahl der Systemtakte zum Zeitpunkt des Meßtaktsignals T und im Speicher SD die Anzahl der Systemtakte C der Meßperioden abgespeichert. Die Inhalte der Speicher SI, SP, SD können über ein Businterface BI von einem Mikroprozessor einer nicht dargestellten Datenverarbeitungsanlage abgefragt und ausgewertet werden. Bei dieser Auswertung wird die Länge des digitalen Signals aus der ganzzahligen Anzahl der Impulse und dem Quotienten aus der Systemtaktsumme im Speicher SP und der Systemtaktsumme im Speicher SD gebildet. Der zeitliche Verlauf der einzelnen Signale wird im folgenden anhand der Figuren 2 bis 5 dargestellt.

FIG 2 zeigt das Systemtaktsignal C, das gegenüber dem in FIG 4 dargestellten digitalen Signal S höherfrequenter ist. In FIG 3 ist der Einfachheit halber lediglich die positive Flanke des Systemtaktsignales C durch Pfeile angedeutet. Die positiven Flanken des Systemtaktsignals C (FIG 3) fallen mit den positiven Flanken des digitalen Signals S (FIG 4) zusammen.

Angenommen der zuletzt detektierte Impuls des digitalen Signals S war der dreiunddreißigste Impuls seit dem Auftreten des letzten Meßtaktsignals T dann wird mit der folgenden positiven Flanke des digitalen Signals S der vierunddreißigste Impuls im Impulszähler IZ (FIG 1) gezählt.

Gleichzeitig beginnt die Zählung des Systemtaktes C durch den Systemtaktzähler SZ der seine Zählung bei eins beginnt. Beim Auftreten des Meßtaktsignals T zum Zeitpunkt $t_M$ wird der Wert 7 vom Systemtaktzähler SZ in den Speicher SP für die Phasenlage übernommen. Wenn zum Zeitpunkt $t_p$, also am Periodenrande die positive Flanke des folgenden Impulses des digitalen Signals S detektiert wird, hat der Systemtaktzähler SZ insgesamt neunzehn Systemtakte gezählt, so daß der Wert 19 dem Speicher SD für die Periodendauer übergeben wird. Die Anzahl der insgesamt gezählten digitalen Signale ergibt sich damit aus der ganzzahligen Anzahl von vierunddreißig Impulsen und dem gebrochenen Anteil von 7 zu 19 Impulsen. Wenn die Summe des digitalen Signals S proportional zu einer bestimmten Frequenz ist, wenn also beispielsweise 100 Impulse einer Frequenz von 5 MHz entsprechen, dann läßt sich nun mittels Dreisatzrechnung genau bestimmen, welcher Frequenz 34 7/19 Impulse entsprechen.

Mit der Anordnung gemäß dem in FIG 6 dargestellten Blockschaltbild läßt sich eine genauere Impulszählung erreichen. Das Blockschaltbild gemäß FIG 6 unterscheidet sich vom Blockschaltbild gemäß FIG 1 dadurch, daß parallel zu der Schaltungsanordnung nach FIG 1 eine zweite identische Schaltungsanordnung verwendet wird, wobei das digitale Signal S zusätzlich auf den Eingang der zweiten Flankenerkennungseinheit FE2 geführt ist und das Systemtaktsignal C mittels eines Inverters I invertiert wird. Die zweite Schaltungsanordnung arbeitet auf dieselbe Weise wie die erste Schaltungsanordnung, wobei jedoch das digitale Signal S in der Flankenerkennungseinheit 2 bezüglich des invertierten Systemtaktsignales $\overline{C}$ synchronisiert wird.

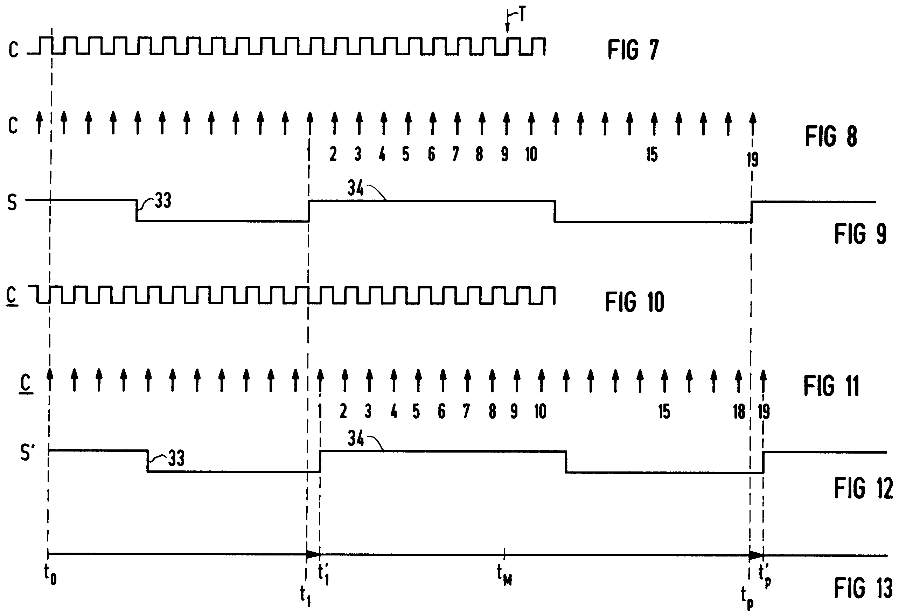

Die Funktionsweise der Schaltungsanordnung gemäß FIG 2 wird im folgenden anhand der in den Figuren 7 bis 13 dargestellten Diagramme erläutert. Der bereits aus den Figuren 2 bis 4 bekannte Verlauf des Systemtaktsignals C und des digitalen Signals S ist in den Figuren 7 bis 9 identisch wiedergegeben. In FIG 10 ist das invertierte Signal $\overline{C}$ dargestellt. Es ist erkennbar, daß die positiven Flanken des Systemtaktzyklus in FIG 11 gegenüber den in FIG 8 dargestellten um eine halbe Periode des Systemtaktsignals C (FIG 7) versetzt sind (vgl. gestrichelte Linie beim Zeitpunkt $t_0$). Damit ist auch das digitale Signal S' (FIG 1,2), das durch das invertierte Systemtaktsignal $\overline{C}$ synchronisiert wird, um die gleiche Zeit gegenüber dem digitalen Signal S (FIG 9) versetzt. Beim Auftreten des Meßtaktsignals T zum Meßtaktzeitpunkt $t_M$ entspricht also der Zählerstand der ersten Auswerteschaltung - wie anhand der Figuren 2 bis 6 beschrieben - einem Wert von 34 7/19 Impulsen. Wie bereits ausgeführt, erfolgt die Zählung in der zweiten Schaltungsanordnung identisch zur ersten Schaltungsanordnung, jedoch ergibt sich bedingt durch den Zeitversatz, der durch das invertierte Systemtaktsignal $\overline{C}$ verursacht ist das der Wert des Speichers SP2 für die Phasenlage und eventuell der des Periodendauerspeichers SD2 verschieden von den Werten der Speicher SP1 und SD1 sind. Beim Auftritt des Meßtaktsignals T hat nämlich der zweite Systemtaktzähler SZ2 erst 8 Systemtakte gezählt und in den Speicher SP2 übergeben. Da sich jedoch durch den Zeitversatz an der Periodendauer der gemessenen Periode des digitalen Signals S bzw. S' im dargestellten Beispiel nichts verändert hat, wird in den Periodendauerspeicher SD2 am Ende der Periodendauer der Wert 19 abgelegt, so daß sich lediglich der im Speicher SP2 abgelegte Wert von dem im Speicher SP1 abgelegte Wert unterscheidet. Die Berechnung der Anzahl der Impulse ergibt sich damit aus der halben Summe der im ersten und zweiten Impulsspeicher SI1, SI2 abgelegten Werten und aus der Summe der im ersten und zweiten Speicher SP1, SP2 für die Phasenlage abgelegten Werte, dividiert durch die Summe aus den im ersten und zweiten Speicher SD1, SD2 abgelegten Werten für die Periodendauer. Nach dem Ausführungsbeispiel ergibt das -

$$1/2\ (SI1 + SI2) + (SP1 + SP2)/(SD1 + SD2) = 1/2\ (34 + 34) + (9 + 8)/(19 + 19)$$

- Impulse

**Patentansprüche**

1. Verfahren zur Zählung digitaler Impulse nach folgenden Schritten:

   1.1 Ein digitales Signal (S) wird mit einem Systemtakt (C) synchronisiert, dessen Frequenz größer ist als die doppelte Maximalfrequenz des digitalen Signals (S),

   1.2 zwischen jeweils zwei periodischen Meßtaktsignalen (T) wird die ganzzahlige Anzahl der Impulse des digitalen Signals (S) gezählt,

   1.3 bei Beginn jeder Periode des digitalen Signals (S) wird eine Zählung des Systemtakts (C) gestartet,

   1.4 die Summe der Systemtakte (C) bis zum Auftreten des Meßtaktsignals (T) wird als Periodenteilsumme gezählt,

   1.5 die Summe der Systemtakte (C) zwischen zwei Meßtakttsignalen (T) wird als Periodensumme gezählt,

   1.6 die Anzahl der digitalen Impulse zwischen zwei Meßtaktsignalen (T) wird bestimmt aus der ganzzahligen Anzahl der Impulse und dem Quotienten aus Periodenteilsumme und Periodensumme.

2. Verfahren nach Anspruch 2, mit folgenden Schritten:

   2.1 Aus dem Systemtaktsignal (C) wird ein invertiertes Systemtaktsignal ($\overline{C}$) gebildet,

   2.2 das digitale Signal (S) wird zusätzlich - entsprechend den Schritten 1.1 bis 1.5 - mit dem invertierten Systemtaktsignal ($\overline{C}$) ausgewertet, wobei eine zweite ganzzahlige Anzahl der Impulse, eine zweite Periodenteilsumme und eine zweite Periodensumme gezählt werden,

   2.3 die Anzahl der Impulse des digitalen Signals (S) zwischen zwei Meßtaktsignalen (T) wird bestimmt aus der halben Summe der ersten und der zweiten ganzzahligen Anzahl der Impulse und dem Quotienten aus erster und zweiter Periodenteilsumme und erster und zweiter Periodensumme.

3. Schaltungsanordnung zur Durchführung des Verfahrens mit

   3.1 Mitteln zur Synchronisation eines digitalen Signals (S) mit einem Systemtakt (C)

   3.2 Mittel zur Zählung

      3.2.1 der ganzzahligen Anzahl der Impulse des digitalen Signals (S)

      3.2.2 des Systemtakts (C), wobei dessen Zählung jeweils mit dem Beginn einer Periode des digitalen signals (S) gestartet wird,

   3.3 Mitteln zur Erfassung der ganzzahligen Anzahl der Impulse und der Summe der Systemtaktsignale (C) beim Auftreten eines Meßtaktsignales (T), sowie zur Erfassung der Summe der Systemtaktsignale (T) am Ende einer Periode des digitalen Signals (S),

   3.4 Mittel zur Berechnung der Impulse des digitalen Signals (S) aus der ganzzahligen Anzahl der Impulse und dem aus den Systemtaktsignalen (C) bestimmbaren gebrochen rationalen Anteil.

4. Schaltungsanordnung nach Anspruch 3 mit

   4.1 Mitteln zur Bildung eines invertierten Systemtakts ($\overline{C}$),

   4.2 zu den Merkmalen 3.1. bis 3.3 identischen Mitteln,

   4.3 Mitteln zur Berechnung der Anzahl der Impulse des digitalen Signals (S) aus der halben Summe der ersten und der zweiten ganzzahligen Anzahl der Impulse und aus der Summe der ersten und zweiten Systemtaktsignale (C,$\overline{C}$) beim Auftreten des Meßtaktsignals dividiert durch die Summe der ersten und zweiten Systemtaktsignale (C,$\overline{C}$)

pro Periode.

FIG 1

C ⎍⎍⎍⎍⎍⎍⎍⎍⎍⎍⎍⎍⎍⎍⎍⎍⎍⎍⎍⎍⎍⎍⎍⎍⎍⎍ ⊢T

**FIG 2**

C ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑

1 2 3 4 5 6 7 8 9 10      15      19 **FIG 3**

S ⌐33 ⌐34

**FIG 4**

$t_1$        $t_M$        $t_P$ **FIG 5**

EP 0 570 608 A1

EP 0 570 608 A1

FIG 6

T
S
C
I
C

FE1 ST1 TE1 CEN1 IZ1 SI1

SV1 LOAD1 SP1

SZ1 SD1

CS
ADRESSEN
DATEN

BUS IN

FE2 ST2 TE CEN IZ2 SI2

CLK CLK CLK CLK

SV LOAD SP2

SZ2 SD2

CLK CLK

BI

C ⊢T                                                                    FIG 7

C  ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑     FIG 8
        2 3 4 5 6 7 8 9 10        15        19

S      ⌐33      ⌐34                                                     FIG 9

C̲                                                                       FIG 10

C̲  ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑ ↑    FIG 11
        1  2 3 4 5 6 7 8 9 10        15        18 19

S'     ⌐33      ⌐34                                                     FIG 12

$t_0$              $t_1$        $t_M$              $t_p$               FIG 13
                   $t'_1$                          $t'_p$

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | WO-A-9 204 634 (SUNDSTRAND) <br> * Seite 4, Zeile 9 - Seite 5, Zeile 24; Abbildungen 3-5 * <br> --- | 1-4 | G01R23/10 <br> G06F7/62 |
| X | FR-A-2 370 286 (GIRLING) <br> * Seite 1, Zeile 38 - Seite 2, Zeile 14 * <br> * Seite 8, Zeile 10 - Seite 9, Zeile 1; Abbildungen 1-4 * <br> --- | 1,3 | |
| A | IEEE TRANSACTIONS ON INSTRUMENTATION AND MEASUREMENT <br> Bd. 40, Nr. 3, Juni 1991, NEW YORK US <br> Seiten 606 - 610 , XP259715 <br> M.PROKIN 'DOUBLE BUFFERED WIDE-RANGE FREQUENCY MEASUREMENT METHOD FOR DIGITAL TACHOMETERS' <br> * Seite 606, linke Spalte, Zeile 1 - Seite 606, rechte Spalte, Zeile 39; Abbildungen 1,2 * <br> * Seite 608, linke Spalte, Zeile 35 - Seite 608, linke Spalte, Zeile 50 * <br> ----- | 1-4 | |

| | | RECHERCHIERTE SACHGEBIETE (Int. Cl.5 ) |
|---|---|---|
| | | G01R <br> G06F |

Der vorliegende Recherchenbericht wurde für alle Patentansprüche erstellt

| Recherchenort | Abschlußdatum der Recherche | Prüfer |
|---|---|---|
| DEN HAAG | 13 JANUAR 1993 | KHAZAM U.J. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
...........................................................................
& : Mitglied der gleichen Patentfamilie, übereinstimmendes Dokument

EPO FORM 1503 03.82 (P0403)